(19) **Europäisches Patentamt European Patent Office Office européen des brevets**

(11) **EP 1 623 503 B1**

(12) **EUROPEAN PATENT SPECIFICATION**

(45) Date of publication and mention
of the grant of the patent:
**14.03.2012 Bulletin 2012/11**

(51) Int Cl.:
**H03L 7/23** (2006.01)

(21) Application number: **04751256.1**

(22) Date of filing: **03.05.2004**

(86) International application number:
**PCT/US2004/013780**

(87) International publication number:
**WO 2004/100380 (18.11.2004 Gazette 2004/47)**

(54) **METHOD AND APPARATUS FOR A LOW JITTER DUAL-LOOP FRACTIONAL -N SYNTHESIZER**

VERFAHREN UND VORRICHTUNG FÜR EINEN DOPPELSCHLEIFEN-FRAKTIONAL-N-SYNTHESIZER MIT NIEDRIGEM JITTER

PROCEDE ET DISPOSITIF POUR SYNTHETISEUR N FRACTIONNEL A DOUBLE BOUCLE ET FAIBLE NIVEAU DE GIGUE

(84) Designated Contracting States:
**DE FR GB**

(30) Priority: **02.05.2003 US 467813 P**
**30.09.2003 US 675543**
**30.09.2003 US 675529**

(43) Date of publication of application:
**08.02.2006 Bulletin 2006/06**

(73) Proprietor: **Silicon Laboratories, Inc.**
**Austin, TX 78735 (US)**

(72) Inventors:
• **THOMSEN, Axel**
**Austin, TX 78756 (US)**
• **HUANG, Yunteng**
**Irvine, CA 92620 (US)**
• **HEIN, Jerrell, P.**
**Driftwood, TX 78619 (US)**

(74) Representative: **Harding, Richard Patrick**
**Marks & Clerk LLP**
**4220 Nash Court**
**Oxford Business Park South**
**Oxford**
**OX4 2RU (GB)**

(56) References cited:
**US-A- 5 604 468        US-A- 5 790 614**
**US-B1- 6 404 246**

**Description**

This application relates to integrated circuit devices more particularly to integrated circuits utilized in generating clock signals.

Clock sources typically utilize a resonator such as a crystal oscillator or surface acoustic wave (SAW) device. Precision in traditional clock sources utilizing crystal oscillators is determined by the accuracy of the cut of the crystal and the calibration performed after the cut. For example frequency tuning may be achieved by sputtering gold after cutting. Fixed frequency sources such as crystals have typically provided better phase noise performance than the phase noise performance associated with variable frequency source such as, e.g., a voltage controlled oscillator (VCO). That is due, at least in part, to the fact that the variable elements (e.g. the varactor) associated with the VCO used to vary the frequency have higher losses than fixed elements such as the capacitors in a fixed source.

However, resonators typically have a limited optimum range due to manufacturing constraints. That is, it is hard to pull a crystal over a wide range. However, various applications have requirements for numerous frequencies outside the easy range for a resonator. Typically, a different frequency range will require a different resonator. Accuracy requirements vary for clock sources, but are typically below the parts per million (ppm) range.

It would be desirable to provide a clock source that meets accuracy requirements, allows the use of a resonator that is easy to manufacture and low cost, but can still provide a wide range of output frequencies and suitable phase noise performance.

US 5790614 teaches a digital signal processing technique used to synthesize a finally spaced range of output frequencies using a non-pullable reference oscillator supplied to a frequency synthesizer. The frequency synthesizer forms a part of a phase locked loop that supplies a digital input to the frequency synthesizer.

According to one aspect of the present invention there is provided an apparatus comprising: a phase-locked loop (PLL) circuit including an input for receiving a timing reference signal, a controllable oscillator circuit, and a multi-modulus feedback divider circuit; a control loop circuit including a phase detector, the phase detector being coupled to an output of the controllable oscillator circuit and a timing reference signal; characterized in that the apparatus includes a non-volatile memory storing a stored value corresponding to a desired frequency of an output signal of the controllable oscillator circuit; and in that the apparatus further comprises a selector circuit having inputs coupled respectively to the phase detector of the control loop circuit and to a first control signal corresponding to the stored value in the non-volatile memory, the selector circuit selecting one of the inputs as a digital control signal, the digital control signal being coupled to the feedback divider circuit through a delta sigma modulator and used to control a divide ratio of the feedback divider circuit.

In an embodiment, while the control loop circuit is coupled to supply the digital control signal, the digital control signal is determined according to a detected difference between the oscillator output signal and the reference signal coupled to the control loop circuit. In an embodiment, a temperature compensation circuit is coupled to supply an adjustment value according to a detected temperature, and the digital control signal is adjusted according to the adjustment value, while the control loop circuit is not coupled to supply the control signal to the feedback divider circuit. The apparatus may further include an analog to digital converter circuit coupled to a voltage control input, and the digital control signal is adjusted according to a voltage value present on the voltage control input. The apparatus may further include one of a crystal oscillator and a surface acoustic wave (SAW) resonator supplying the timing reference signal. The control loop circuit may be implemented as a phase-locked loop and include a digital loop filter. The stored value in the non-volatile memory may be based on a control value that was stored as a result of the control loop circuit detecting a lock condition indicating that the oscillator circuit output signal was locked to a reference signal coupled to the control loop circuit. In an embodiment the control loop circuit is implemented as a low bandwidth phase-locked loop and a bandwidth of the PLL circuit is substantially higher than the low bandwidth of the control loop circuit.

According to another aspect of the present invention there is provided a method comprising: providing a phase-locked loop (PLL) circuit including an input for receiving a timing reference signal, a controllable oscillator circuit, and a multi-modulus feedback divider circuit; providing a control loop circuit including a phase detector coupled to receive an output of the controllable oscillator circuit and a timing reference signal; characterized by the steps of: storing a stored value corresponding to a desired frequency of an output signal of the controllable oscillator circuit in a non-volatile memory; selecting in a selector circuit a source for a control value for controlling a divide ratio of the feedback divider circuit to be from one of the control loop circuit and a stored value stored in the non-volatile memory indicative of a desired frequency of an output signal of the PLL circuit; and supplying the control value to control the divide ratio to the feedback divider circuit through a delta sigma modulator.

The method may further include supplying the PLL circuit with a timing reference signal from one of a crystal oscillator and a surface acoustic wave (SAW) device as an input into the PLL circuit. In an embodiment, the PLL circuit is a fractional N loop such that a period of the timing reference signal can be a non-integer multiple of a period of an output signal generated by the PLL circuit. In an embodiment, the control loop circuit is a low bandwidth phase-locked loop and the PLL circuit is a phase-locked loop having a substantially higher bandwidth than the low bandwidth of the control loop circuit. The method may further include determining the control signal supplied to the PLL circuit to control the divide ratio at least in part according to a detected temperature. The method may further include determining the control signal supplied to the PLL circuit to control the divide ratio at least in part according to a control voltage supplied on a voltage control input terminal to adjust output frequency of the PLL circuit. The method may further include storing a control signal corresponding to the divide ratio supplied to the PLL circuit to cause the PLL circuit to generate the output signal with a frequency corresponding to the timing reference signal, in response to a lock condition detected by the control loop circuit. The method may further include selecting a source for the control value from one of the control loop circuit or from a non-volatile memory storing a stored control value corresponding to desired frequency of the oscillator output signal.

In order that the invention may be more fully understood, reference will now be made, by way of example only, to the accompanying drawings, in which:

Figure 1 illustrates a device in which an integrated circuit and a crystal are packaged in a standard six pin VCXO ceramic package.

Figure 2 illustrates a device in which an integrated circuit and a crystal are packaged in a standard four pin XO ceramic package.

Fig. 3 illustrates a block diagram of an exemplary integrated circuit suitable for use as the integrated circuit in Figs. 1 or 2.

Fig. 4 illustrates alternative serial communication terminals for programming and for receiving a configuration clock according to an embodiment of the invention.

Fig. 5 illustrates exemplary read and write formats utilized for communicating over a serial port.

Fig. 6 illustrates exemplary use of Manchester encoding for data supplied over the serial port.

Fig. 7 illustrates exemplary use of a calibration clock over the serial port.

Fig. 8 illustrates an exemplary embodiment of the digitally controlled oscillator utilized in Figs. 3 and 4.

Fig. 9 illustrates a block diagram of an exemplary phase selectable divider circuit that may be utilized in the multi-modulus divider in Fig. 8.

Fig. 10 illustrates operation of the phase selectable divider of Fig. 9.

Fig. 11 illustrates an exemplary implementation of a multi-modulus divider.

Fig. 12 illustrates operation of the multi-modulus divider shown in Fig. 11.

The use of the same reference symbols in different drawings indicates similar or identical items.

## DESCRIPTION OF THE PREFERRED EMBODIMENT(S)

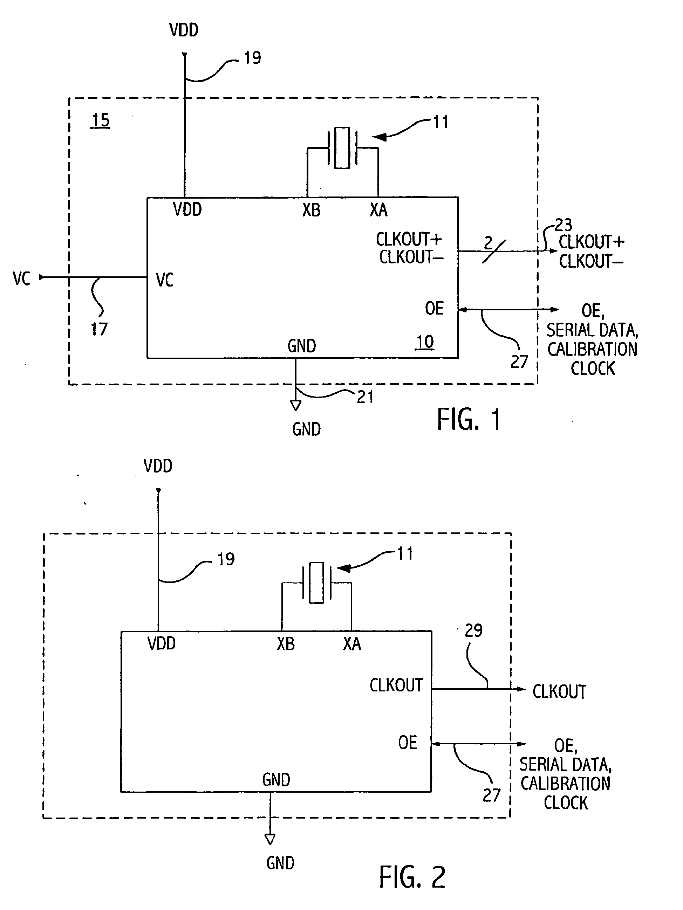

Referring to Fig. 1, a high level diagram shows a clock source device that includes an integrated circuit 10 coupled to a crystal 11. In one embodiment both the integrated circuit 10 and the crystal 11 are packaged in a standard ceramic package 15 that is typically utilized for packaging a voltage controlled crystal oscillator (VCXO). Note that another resonating device such as a surface acoustic wave (SAW) resonator may be utilized in place of crystal 11. In the illustrated embodiment, the package 15 includes standard input/output signals including a voltage control input 17, a power and ground input, 19 and 21 respectively, differential clock outputs and an output enable (OE) pin 27. Fig. 2 illustrates a four pin XO package implementation in which the control voltage input 17 is not utilized and the output clock 29 is single ended. A six pin XO package configuration may also be utilized in which the control voltage input on the package is not connected when the package 15 is mounted to a board. Other packaging alternatives for the integrated circuit with or without the crystal oscillator or SAW may also be utilized.

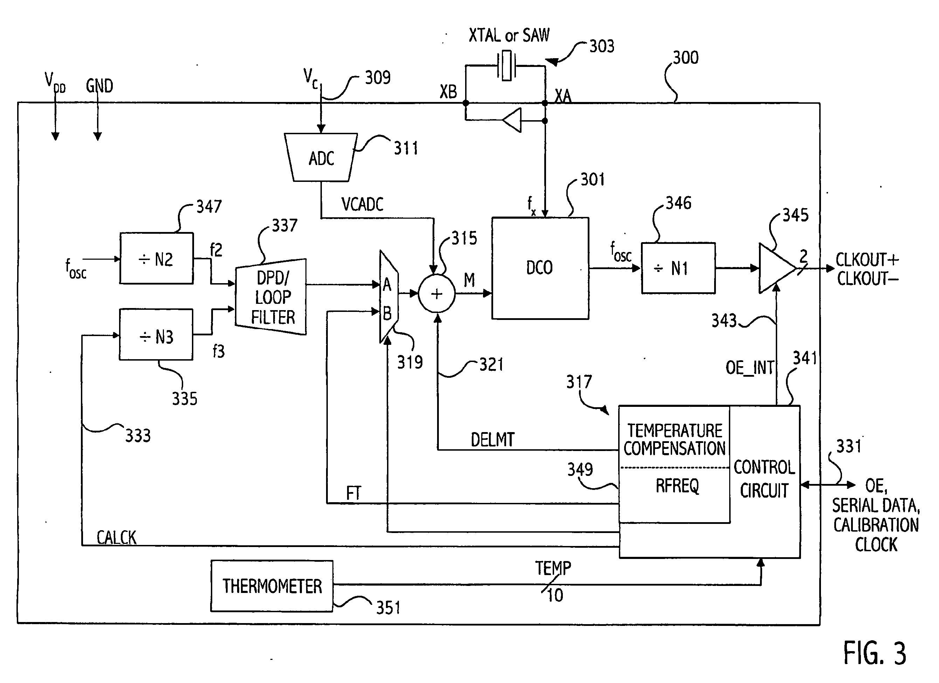

Referring to Fig. 3, a block diagram illustrates an embodiment of integrated circuit 10 that provides a fixed frequency or voltage controlled clock source. In Fig. 3, the integrated circuit is packaged in a six pin VCXO package. Integrated circuit 300 includes a digitally controlled oscillator (DCO) 301. With the use of a fractional N phase-locked loop (PLL), a crystal based reference clock 303 can be multiplied up by a rational number to supply a wide variety of output frequencies. The fractional N loop can be viewed as a digitally controlled oscillator, where the output frequency is controlled by the rational digital number M according to Fout = M×Fref. Thus, the DCO 301 can be implemented as a fractional N PLL providing a wide range of output frequencies output $f_{osc} = M \times f_x$ where $f_x$ is supplied from oscillator 303. The precision of M can be to the level of a few parts per billion. An important criteria is to ensure that a DCO, such as illustrated in Fig. 3, meets the phase noise specifications typically achieved by a fixed frequency crystal or SAW based oscillator. A standard of interest would be for example the SONET standard for jitter generation. That will be explained in more detail below.

Fractional N phase-locked loops (PLLs) allow the multiplication of an incoming reference clock by a rational rather than an integer number as is common in traditional PLL designs. Such a multiplication requires the use of a multi-modulus divider in the feedback path. Such a divider will divide not by a fixed integer, but by a sequence of integers that over time approximates the rational number desired. This sequence can be generated by a digital delta sigma modulator which shapes the quantization noise added to the rational number with a high pass filter. Thus the resulting phase noise is also shaped by a high pass filter. The overall noise contribution from the fractional PLL depends on two major factors. The first major factor is the ratio of the update rate of the PLL (generally the reference clock rate) and the loop bandwidth of the PLL, a measure similar to the oversampling ratio (OSR) in delta sigma analog to digital converters (ADCs). A higher OSR allows for better suppression of quantization noise in the band of interest. For a given update rate the noise contribution can be reduced by lowering the loop bandwidth. The second major factor contributing to noise is the quantization error applied at the divider, which is the clock period of the clock feeding the multi-modulus divider.

Additional to the noise sources stated above, noise in a PLL has 2 other main contributors: The first other main contributor is noise from the voltage controlled oscillator (VCO). An integrated LC VCO exhibits 3 noise regions, close in $1/f^3$, intermediate $1/f^2$, and high frequency white noise that is frequency independent. For example, exemplary corners defining the three regions are at 100 KHz and 100 MHz. For an integrated LC VCO oscillating in the GHz range, the $1/f^3$ region is significant, whereas the white noise region is insignificant. When embedded in a PLL the noise transfer function to the output of the PLL is a high pass filter with a corner at the loop bandwidth. Wider loop bandwidth improves the noise contribution from the VCO. If the bandwidth of the loop exceeds the 1/f corner of the oscillator, the overall phase noise performance tends to be very competitive with the performance of prior art fixed frequency crystal or SAW based oscillators in applications such as SONET.

The second other main contributor to noise in a PLL is noise from the reference clock. Similar noise regions exist as above. If this clock is generated from a fixed crystal oscillator, it is generally very competitive at low frequency ($1/f^3$ and $1/f^2$) but with a significant white noise contribution. Narrower loop bandwidth improves the noise contribution of this source.

The choice of loop bandwidth is an optimization to reduce noise from various sources. Given today's state of the art in LC oscillator design in terms of phase noise and oscillation frequency, and the ability of a state of the art CMOS process to implement a high speed multi-modulus divider and a high speed delta sigma modulator, it is now possible to optimize the noise budget to yield a clock source that can exceed standards such as SONET and to enable this architecture as a clock source.

Good jitter performance of the DCO loop is facilitated by implementation of the loop filter as a digital filter, which is a technique that allows an accurate implementation of the loop filter that is properly matched to the corners and the order of the noise shaping function and therefore can best reduce the jitter contribution from that source. A digital loop filter implementation was described in application WO 02/05428 A2 entitled Digitally Synthesized Loop Filter Circuit Particularly Useful for a Phase Locked loop.

Additionally the current phase error can be computed as the integral of all instantaneous frequency errors as they were computed in the delta sigma modulator that controls the multi modulus divider. Through subtraction in the analog or digital domain, the phase error can be cancelled and thus strongly reduced as a noise source. As a result the bandwidth can be increased and thus overall better jitter performance can be achieved.

The device illustrated in Fig. 3 can function as a voltage-controlled crystal oscillator (VCXONCSO) or as a fixed-frequency clock source (XO/SO). A register bit setting may be used to select between the modes of operation. In voltage-controlled oscillator operational mode a control voltage is received on the VC analog voltage input port 309. The on-chip analog to digital converter (ADC) 311 converts the control voltage VC into a digital control word (VCADC) supplied to summing circuit 315, which generates the control signal M for the DCO 301. When operating in VCXO/VCSO mode, the selector circuit 319 selects 319 input B, which is coupled to the reference frequency (RFREQ) control value stored in a portion 349 of non-volatile storage 317. The control value from the selector circuit may be summed in summing circuit 315 with a temperature compensation value (DELMT) supplied on node 321 as described further herein, as well with as the control VCADC, and the sum is supplied to DCO 301 as the control signal to determine the DCO output. In VCXO/VCSO mode the RFREQ provides a center frequency that is adjusted by VCADC. If temperature compensation is not used, a value for DELMT is selected so as to not effect the output of DCO 301.

When operating as a fixed frequency clock source, the selector circuit also selects 319 input B, to supply the reference frequency (RFREQ) control value stored in a portion 349 of non-volatile storage 317. That control value may be summed in summing circuit 315 with a temperature compensation value (DELMT) supplied on node. The sum from summing circuit 315 is supplied to DCO 301 as the control signal to determine the DCO output. When operating as a fixed-frequency clock source (XO/SO), the ADC 311 is powered down and its output is fixed to its mid-scale value so as not to affect the DCO 315.

The use of a DCO as a clock source has several advantages. Digital control of the output frequency allows for storage of calibration parameters in non-volatile memory 317. Also, the DCO can be embedded in an outer phase locked loop as described further herein. This outer loop includes a phase detector with digital output and a digital loop filter 337 and the DCO 301. When the outer loop is in lock to a reference frequency, the value present at the input to the DCO 301 is the proper multiplier to achieve this frequency in an open loop operation. Therefore this value can be stored while in lock and recalled later for operation in open loop as a clock source. The loop bandwidth of the inner loop, as described above, is preferably greater than the 1/f corner. Depending on specific implementations, the loop bandwidth of the inner loop may range from approximately 10 KHz to approximately 10 MHz. The loop bandwidth of the outer loop is preferably much lower, e.g., below approximately 1 KHz and even as low as 50 Hz or lower. Note also that the inner loop is implemented to adjust quickly to changes as compared with the outer loop. Having the outer loop have a low bandwidth allow attenuation of jitter present on the reference clock input to the outer loop, which in turn can reduce jitter present in a stored control value to control the output of the inner loop.

The embodiment illustrated in Fig. 3 has the capability of generating and storing a digital control value for DCO 301 corresponding to clock signal received via a calibration input. In that way, the device can be programmed to provide a clock having a desired output frequency. When operating in calibration mode, as described further herein, a calibration clock signal is supplied, e.g., on terminal 331 and via signal line 333 to divider 335. The calibration clock is compared to the output of the DCO 301 in phase and frequency detector 337 and an error signal is generated and filtered and supplied to adjust the output of DCO 301. When the output of the DCO has locked to the supplied calibration clock, the value of M may be stored. The calibration clock feature is useful, e.g., so that the device can lock its output clock to the calibration clock using an internal PLL, and control factors used to lock the PLL to the calibration clock can be stored for absolute output frequency and/or frequency versus temperature, as described further below. That stored value may then be utilized to control the DCO during normal operation.

In order to supply the a calibration clock and perform necessary programming associated with configuring the clock source, a communication port, e.g. a serial port may be provided. The serial port may be provided as a dedicated programming port or its function can be combined with other I/O terminals. For example, in order to provide a more flexible clock device, according to one embodiment, the OE pin 331 is multi-functional. That is, in one embodiment, the OE terminal functions as a normal enable signal causing the output clock(s) to be either supplied or not according to the voltage level on the OE terminal. In addition, according to an embodiment of the present invention, the OE terminal 331 is also used for programming and calibrating the device 300. In order to program the integrated circuit device, the OE terminal 331 is used to communicate serial data to and from the integrated circuit 300. Thus, in addition to normal enable/disable functionality, the OE pin 331 may serve as a serial port for access to storage locations internal to integrated circuit 10, thus providing programmability. In an embodiment, the OE pin is bi-directional, implemented as an open drain with a weak pull-up. In some embodiments, the serial communication may be unidirectional into integrated circuit 330. In addition, OE terminal 331 can function as a calibration input used to internally generate calibration correction factors using an internal PLL.

Adapting the OE terminal to be multi-functional provides both programmability and calibration capability, and because a standard input terminal is utilized for the functions, no special packaging is required, resulting in low cost for the additional functionality. Significantly, the functions can be performed after the device is packaged and sealed. In addition, low frequency test equipment can be used to provide programming and calibration of the devices in a sealed package without any additional package pins.

In the illustrated embodiment, the output enable (OE) terminal 331 is multi-functional in that in can be used both to provide an output enable function and to provide programming and calibration clock. The multifunction capability of OE terminal 331 may be provided as follows. The output enable signal supplied from an external source to OE terminal 331 is provided to control circuit 341, which may include a sampling circuit and a state machine. The control circuit 341 determines whether the received signal is a valid output enable signal, serial data communication, or a calibration clock. If the signal on OE terminal 341 is determined to be a valid output enable signal, then the signal value on OE pin 331 is utilized to generate an internal output enable control signal 343, which in turn enables (or disables) output drivers 345 that supply the differential clock outputs CLKOUT+ and CLKOUT-.

In one embodiment control circuit 341 determines whether the signal present on I/O terminal 331 is a valid output enable signal, serial data, or a calibration clock as follows. An internal oscillator clock asynchronously oversamples the OE I/O terminal. Any static value (all samples having the same value) that persists more that a predetermined time period, $t_{STATIC}$, is interpreted as a change to or as a valid enable/disable signal and the output clocks are selectively enabled or disabled based on that static value. The time period $t_{STATIC}$ may be programmable. The sampling circuit functions as a deglitching circuit ensuring that short term changes on I/O terminal 331 do not cause changes to the enable/disable control of the output clock terminal(s).

In order to provide bi-directional data communication via I/O terminal 331, a bi-directional serial data format is utilized that includes guaranteed transitions at less than $t_{STATIC}$ intervals. In one embodiment, the serial data format includes an indication of read or write, the register or other internal address, and direction (either data input or output). Because transitions of the serial communication are guaranteed at less than $t_{STATIC}$ intervals, activity on the OE I/O terminal for serial data I/O will not interfere with the normal enable/disable functionality. In addition, a serial data format is selected that is sufficiently complex, e.g., with appropriate error detection capability, to preclude the possibility that a glitch at the OE terminal during normal operation would be inadvertently interpreted as a serial port command.

In order to distinguish between calibration clocks and serial data, a serial data command is utilized that indicates to the device that the calibration clock will be applied next. That command enables the calibration PLL. After this command, the user supplies a clock to the OE terminal 331. The frequency of the calibration clock may be low even though the output frequencies are high due to the use of the divider 347 in the feedback path from the oscillator 301. Note however,

EP 1 623 503 B1

that the frequency of the calibration clock should be high enough to provide transitions at less than $t_{STATIC}$ intervals so as not to interfere with the normal enable/disable operation.

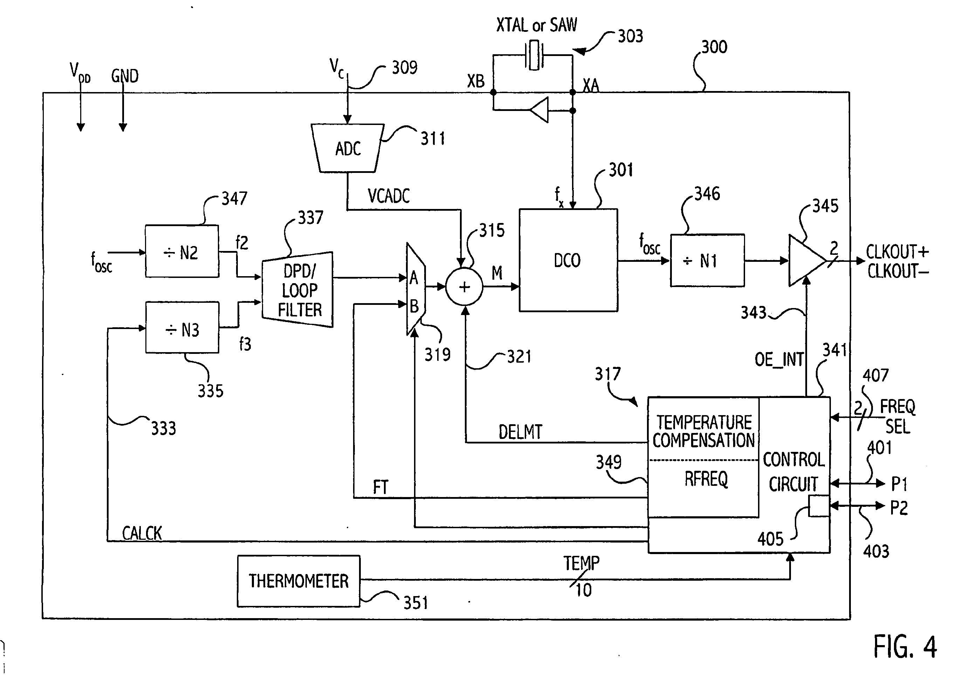

Referring to Fig. 4, in another embodiment the option is provided for using one of two dedicated I/Os on the integrated circuit device. The P1 port 401 is a dedicated I/O that functions as a bidirectional serial port for register data reads and writes, and as a calibration clock input, similar to the function of the OE pin used for programming and calibration described above but without any OE pin functionality. The P2 port 403 is also a dedicated I/O with the same serial bus and calibration clock functionality as P1; however, once programming is completed, P2 can be converted from a dedicated serial port I/O to an input control for the output enable function. Similar to the OE pin described in relation to Fig. 3, an input deglitching circuit 405 guarantees that short term glitches or pulses on the P2 pin are ignored and do not affect the internal buffer disable control. The length of the deglitch interval, also referred to herein as ($t_{STATIC}$) may be programmable via programmable register bits, e.g., by programming the number of consecutive samples required for validation. In one embodiment, the number of samples varies between 1 and 1024. Similar to operation of output terminal 331 described above, all samples of the P2 input should have the same value for the entire duration of the deglitch interval before the state is validated and reflected at the internal buffer control. In one embodiment, the sample clock rate for the deglitch circuit is approximately 10 MHz (fsamp = fosc/512).

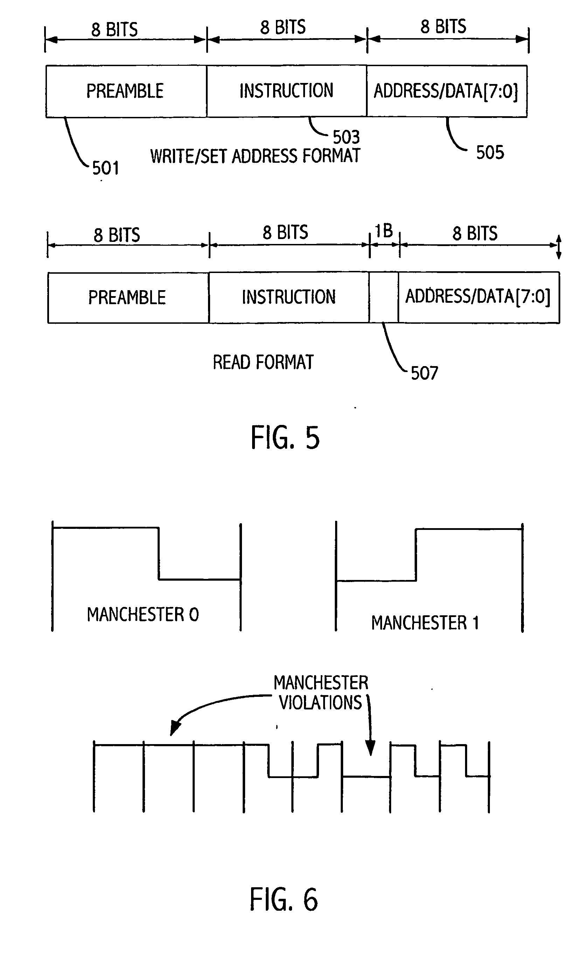

The serial port is typically used during manufacture test to establish the desired device configuration in the on-chip non-volatile memory (NVM) 317. Serial port communications can begin following a power-on-reset of the device. An exemplary command format for the serial bus is shown in Fig. 5. Each transmission has three eight bit bytes of data: the preamble byte 501, the instruction byte 503, and the address/data byte 505. One extra clock cycle 507 exists for the Read command in order to allow time for placing the transmit output of the test equipment hooked up to the device in high impedance before the first read bit is sent by the device. The serial port state machine, which may be part of deglitching circuit 83, returns to its initialized condition if any invalid input data is detected or if no activity occurs on the bus. That feature guarantees that the state machine can always be brought to a known condition before signaling begins. In one embodiment, all data sent from the test equipment (master) to the device (slave) is Manchester encoded with a symbol rate of approximately 10 kbps. The Manchester encoding creates guaranteed transitions in the data pattern that are used by the device to determine the master's transmission rate. In an embodiment, read data sent from the device to the test equipment is in a non-return to zero (NRZ) format, which maximizes the available sampling time for the test equipment master. The test equipment master can sample the read data using the same internal clock used to generate the transmit data.

TABLE 2

| BYTE 1 Instruction | BYTE 2 Address/Data[7:0] | Comments |
|---|---|---|
| 00000000 | AAAAAAAA | Set Address |
| 01000000 | DDDDDDDD | Write |
| 01100000 | DDDDDDDD | Write and Increment Address |
| 11000000 | DDDDDDDD | Read |
| 11100000 | DDDDDDDD | Read and Increment Address |
| 10100000 | AAAAAAAA | Read Stored Address Value |
| 10000000 | XXXXXXXX | Reserved |
| 00100000 | XXXXXXXX | Reserved |

Fig. 6 gives illustrates a Manchester encoded "0" and "1" and also shows the required preamble data pattern. Note that the preamble contains multiple Manchester code violations in order to increase its uniqueness and reduce the chances of false preamble detection.

In still other embodiments the voltage control input 309 may be used as a serial communication port.

Referring again to the embodiment illustrated in Fig. 3, the digitally-controlled oscillator (DCO) 301 is driven by a digital frequency control word M and produces a low jitter output clock. The control word M supplied to the DCO 301 is generated by summing a reference frequency control word (RFREQ) with the VCO ADC 311 output (VCADC), if utilized, and the temperature compensation value (DELMT), if utilized in summer 315. The fixed frequency external crystal 303, SAW, or clock provides a low jitter reference needed to synthesize the output clock. In one embodiment frequency synthesis is done digitally, eliminating sensitive noise entry points.

In one embodiment different calibration approaches with increasing levels of accuracy may be utilized. For some applications, the inherent frequency accuracy and temperature stability of the crystal oscillator, SAW oscillator, or external reference clock may be sufficient. In this case, no calibration features are needed. A register bit may be used to disable calibration correction features, in which case the temperature compensation (DELMT) value is forced to mid-scale so as not to effect the digital control word supplied to DCO 301.

In some applications it may be adequate to perform a one-time characterization of the device with the crystal or SAW type being used, deriving a set of nominal calibration correction factors from this characterization. Following the characterization, these calibration factors may be loaded into the memory of every device without individual calibration. This approach requires some time initially to generate the nominal calibration factors but does not require calibration of each device.

Alternatively, it is possible to individually calibrate each device, generating a unique set of calibration factors for each one. That approach addresses errors due to the performance parameters of each combination of the device and crystal or SAW. The highest level of error reduction is achieved at the cost of increased test time. Individual calibration is most feasible when each device and crystal or SAW is mounted and packaged together and then tested after packaging.

In one embodiment, the method for frequency and temperature calibration of the DCO uses an external calibration clock applied at the serial port (e.g., at the OE pin, P1 or P2). In calibration mode, a digital phase locked loop (PLL) is implemented around the DCO, locking the DCO output clock to an integer multiple of the low frequency input calibration clock. Once the calibration clock is applied, the device internally generates the required calibration correction factors to generate the desired output frequency.

With reference to Figs. 3 and 4, calibration according to an embodiment of the invention operates as follows. First the temperature compensation DELMT (delta M over temperature) is turned off. That forces its contribution to summing circuit 315 to 0. If desired it may be enabled after the calibration is complete. If the device is being used as a VCO, VCO mode should be enabled and the analog input $V_c$ 309 should be set to its mid-scale voltage during the calibration. That sets the analog to digital converter 311 at midrange. If the device is being used as a fixed frequency oscillator, VCO mode should be disabled to cause the output of the ADC 311 to be at midscale and thus not affect the output frequency. Next the calibration clock frequency range should be selected by selecting the N3 divider value for divider 335. In one embodiment, there are two possible frequency ranges for the calibration clock. A register bit can be used to select the range from 1 to 2 MHz, (the divider value = 1). To select the range from 8 to 16 MHz, the input divider N3 is set to a divider value to 8. The choice of calibration clock frequency range is based on the availability of precision clock sources in the manufacturing test environment. Other embodiments may have different values for the divider block N3 or lack the divider block entirely.

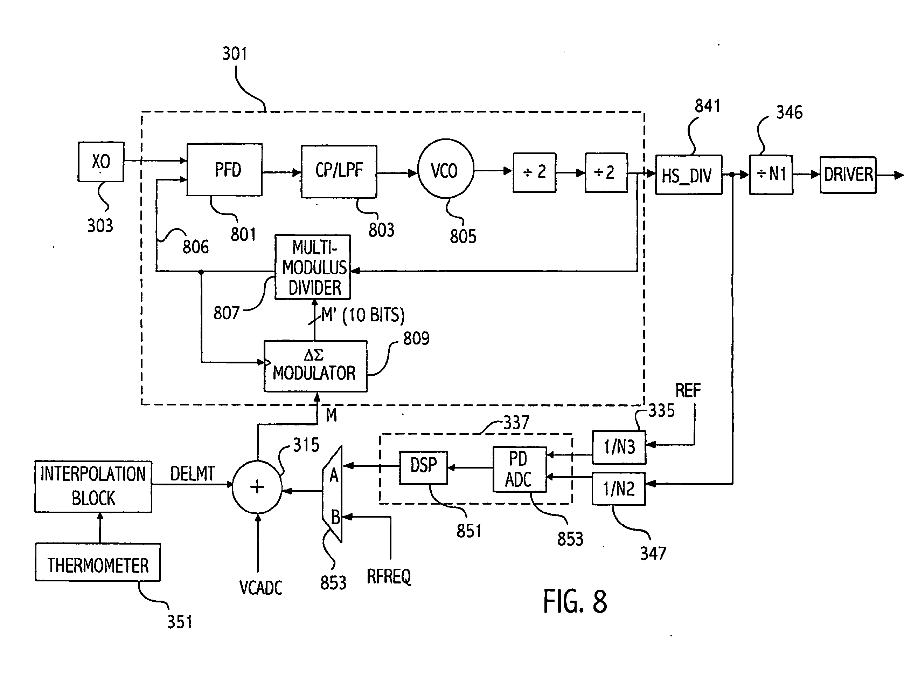

The values for dividers 335 (N3), 347 (N2), and 346 (N1), and the high speed divider (HS_DIV) (see Fig. 8) should be selected along with the calibration clock frequency. The equation relating the calibration clock frequency to the output frequency is as follows for one embodiment of the invention.:

$$f_{OUT} = f_{CALCK} \times N2/(HS\_DIV \times N1) \text{ (for N3=1), or}$$
$$f_{OUT} = f_{CALCK} \times N2/(8 \times HS\_DIV \times N1) \text{ (for N3=8),}$$
$$\text{where HS\_DIV} = [4, 5, 6, 7, 9, 11], 1 \leq N1 \leq 2^7 \text{ and } N2 = 256, 512, 1024$$

Other embodiments may provide other divider values, additional or fewer dividers and thus have different equations for determining the output frequency.

In some embodiments, the calibration loop bandwidth is also selectable. In one embodiment two choices for calibration loop bandwidth are available, which are selected according to a register bit. The wider bandwidth provides faster settling time, but allows more of the calibration clock phase noise to affect the absolute frequency accuracy when the DPLL is frozen. The lower bandwidth has slower settling, but less variation in the absolute frequency value when the DPLL is frozen. The optimal choice is a function of the calibration clock jitter and the absolute frequency accuracy requirement for the application.

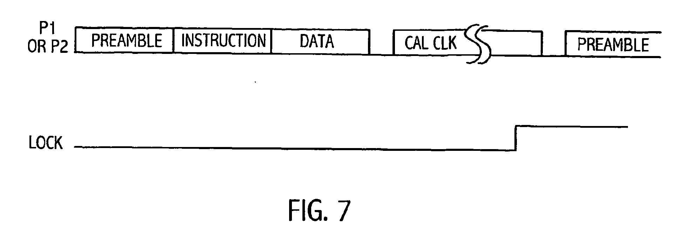

Referring to Fig. 7, the control circuit 341 then receives a command setting the calibration clock on (CCK_ON) register bit to one through a serial port register write, indicating that a calibration clock is to be supplied over the serial port (input/output terminal 27, P1, or P2). Subsequently, the calibration clock can be supplied as an input frequency reference for the calibration PLL. Fig. 7 illustrates a command sequence including a preamble, write command and data followed by application of the calibration clock. In response to the write command, the control state machine selects multiplexer input A from the digital phase detector and loop filter 337, which forms a phase-locked loop with DCO 301 in this configuration. The calibration clock (CALCK) is supplied via node 333 to the divider circuit 335. The digital phase detector and loop filter 337 detects the phase/frequency difference between the calibration clock and the output of the DCO 301 and provides a correction signal to summer 315 through multiplexer 319 to adjust the control signal M supplied to the DCO 301 to reflect that difference. The calibration clock is applied for sufficient amount of time to allow the PLL to settle and establish the control factors needed to lock the DCO 301 output clock to an integer multiple of the low frequency input calibration clock. In other embodiments the DCO may lock to a fractional multiple (e.g., a ratio of integers) of the calibration clock according to the dividers utilized. Note that because of the divider 347 in the feedback path of the PLL, the calibration clock can be a low frequency signal even for those devices with high speed output clocks. Note that control operations during calibration, e.g., to select the multiplexer input and store the value of M, may be controlled via commands sent to serial port, the result of internal control generated by, e.g., a state machine in control circuit 341, or both.

Once the PLL is locked and settled the calibration clock is stopped as shown in Fig. 7. That causes the internal state of the device to be stored and the CCK_ON bit is automatically reset to zero. The cessation of the clock is detected by the control circuit 341 causing it to freeze the correction or control values internally. If the delay required to detect the cessation of the clock allows the PLL to be disturbed before the control values are stored, a history of the control values can be kept on-chip and the control values that existed before the actual clock cessation can be kept. The values that are stored may be the correction factor generated by the phase detector and loop filter 51 or the value of M when the PLL is locked to the calibration clock (essentially the same as the correction factor but after the summing circuit 315). To avoid any inaccuracies in the frozen register values due to the loss of clock detection delay, a running history of the values is kept and the values that existed immediately before the loss of clock are stored when the PLL is frozen. The running history may be stored in registers in the control circuit 341. The control value(s), along with appropriate divider values, can be stored in the non-volatile memory 317, which may, e.g., be implemented as an EPROM, EEPROM, or any other suitable non-volatile memory. The stored control value is used to generate the control value supplied to the DCO 301 by supplying the control value to summing node 315 during normal operation.

In one embodiment a lock detection mechanism is included for the calibration PLL. A lock detect bit (LOCK) is the result of an analysis of the PLL phase detector output. A retriggerable one-shot is set each time the phase detector output indicates a full-scale condition (phase cycle slip). The retrigger time of the one-shot may be programmable via a register bit. Therefore, if no cycle slip has occurred for the retrigger time, the internal lock detection indicator bit (LOCK) is set to one, indicating that the PLL is in lock. The internal lock detection indicator bit (LOCK) can be queried to verify that the PLL achieved lock during the time the calibration clock was active.

Once the calibration clock has ceased for a sufficient amount of time defined by a predetermined time period, the internal over sampling state machine returns to its reset or initialization state, waiting for further activity on OE, P1 or P2, and ready to receive additional commands. This timeout feature prevents lockup of the state machine, guaranteeing a known starting condition for the user.

Note that the serial communication capability available through input/output terminal 331 also allows a user to program a fixed control value to set oscillator 301 to a specific output frequency by writing to reference frequency storage location 349, supplying that value to the multiplexer 319 and selecting the B input of the multiplexer 319 to be supplied to the summing circuit 315. Additionally, in some embodiments, the divider ratios in some or all of divider blocks may be written and/or read via the serial port provided by input/output terminal.

Note that calibration can also be performed without a calibration clock input. However, that requires multiple serial data writes to the device to set the digital control value supplied, e.g., through summing circuit 315 so that while the control voltage Vc is centered, the clock out signal matches an external calibration clock. By instead using a calibration clock supplied over the serial port, the device can itself find the desired correction value by locking its PLL to the calibration clock.

The on-chip nonvolatile memory (NVM) 317 provides for permanent storage of device configuration settings and calibration settings at manufacture. The NVM memory space includes bits for all of the settings necessary to fully configure the device. The volatile memory space includes duplicate bits for each NVM bit, plus additional bits that do not require nonvolatile storage. In one embodiment, the non-volatile memory is one time programmable. A primary (M1) and secondary (M2) NVM space may be provided to allow the NVM settings to be written twice during the lifetime of the device. A status register may be used to indicate the current status of M1 and M2. Data is written from volatile memory, such as registers, into NVM using the STORE command. All volatile memory bits with duplicates in the NVM space are written with one command. The first time the STORE command is executed, the M1 NVM space is written. When the write is initiated, a status bit (M1_WR) is permanently set. Once the write is completed, STORE is reset to zero, a read of M1 is done, and the result is compared to the volatile memory settings. If there is a match, then the NVM write has been successful and the M1_CHK status bit is permanently set. The next time the STORE command is executed, the M2 NVM space will be written. After device powerup or reset, the NVM status bits are checked and the appropriate NVM memory space downloaded into the volatile memory. The appropriate NVM space may also be downloaded on command using the RECALL register bit. Once the download is complete, RECALL is reset automatically.

Upon power up, the device internally executes a power on-reset (POR) which resets the internal device logic, loads the various setting stored in the non-volatile memory into volatile memory (e.g. the various control registers), and places the device output into high impedance. A register bit may also be used to initiate a reset.

In one embodiment, the center frequency of the device is determined by the reference frequency (RFFREQ) supplied to the DCO as control input M and the HS_DIV (see Fig. 8) and N1 output divider values. In one embodiment the device has the capability of storing four unique sets of RFREQ, HS_DIV, and N1 values representing four unique selectable output frequencies. There need not be a relationship between the four frequencies desired. That feature is useful in applications where a different output frequency is required depending on the system configuration. The FRQSEL [1:0] inputs 407 (Fig. 4) select which set of RFREQ, HS_DIV, and N1 values are used. If this feature is not desired, the FRQSEL[1:0] pins can be left floating, in which case default values are selected.

Note that the devices illustrated in Figs. 3 and 4 can provide temperature compensation. That compensation is achieved by supplying the appropriate compensation value from non-volatile memory 317 based on the temperature detected by thermometer 351. Calibration for temperature compensation involves generating digital correction factors for various temperatures of interest.

In one embodiment temperature compensation values are determined as follows. First a reference temperature point is determined. The calibration at this temperature sets the RFREQ value to the DCO and all other temperature/ frequency points are calculated with respect to this reference point The reference temperature does not have to be the nominal ambient temperature of operation. To establish the reference temperature calibration point, a temperature calibration point register (TCP[2:0]) is set to 000, FRQSEL[1:0]=11 (if that feature is provided), and the device is brought to the desired reference temperature. The calibration clock is then applied through the serial port. When the clock is stopped, the M value corresponding to the frozen frequency and the temperature value are stored in the RFREQ_11 and RTEMP RAM registers, respectively. The stored values of M and the temperature are the values that existed immediately before the clock was stopped to avoid any glitches that might occur after the calibration clock is stopped.

To generate the calibration points across temperature, after establishing the reference temperature calibration point, TCP[2:0] is set to 001 to indicate the next temperature calibration point is being established, and FRQSEL[1:0] is set to 11, and the device is brought to the desired temperature. The calibration clock is applied as described previously. When the clock is stopped, the frozen delta-frequency value (relative to RFREQ_11) is stored in a DELMT1 register. The frozen delta-frequency value = (M at the reference temperature) - (M at the next temperature calibration point). The associated temperature is stored in the TEMP 1 register. For each additional temperature calibration point, the temperature calibration point register is incremented and the calibration clock is reapplied at the desired temperature, and the new frozen delta-frequency value is stored along with the corresponding temperature. The temperature and delta M values are subsequently stored in non-volatile memory. During operation the M value at the reference temperature is used when the thermometer 351 indicates the reference temperature and appropriate offsets (supplied as DELMT) are supplied according to the temperature detected by thermometer 351. In other embodiments, the value of M at the particular temperature is stored, rather than delta M, and that value is supplied for temperature compensation.

In one embodiment the device can store up to six calibration points (frequency and temperature pairs), including the reference point, to calibrate the device across temperature. In normal operation with the temperature compensation feature turned on, the device interpolates between the provided calibration points using a polynomial of order N-1, where N is the umber of calibration points to be used, which in one embodiment is programmable using register bits. For example, if values are written into RFREQ_11, DELMT1, DELMT2, and DELMT3 while DELMT4 and DELMTS are not to be used, the user set N=4 so that a 3rd order polynomial interpolation is used.

As illustrated in Fig. 4, and described above a multi-frequency feature is available using the frequency select inputs FREQSEL[1:0]. If the multi-frequency feature is used, temperature calibration for the additional frequencies is achieved by holding the device at the reference temperature, setting FREQSEL[1:0]=10, and reapplying the calibration clock at the appropriate frequency. When the clock is stopped, the frozen frequency control value is stored in RFREQ_ 10. If a third and fourth frequency are desired, repeat the above procedure with FRQSEL[1:0]=01 and 00, respectively.

In order to additionally compensate for temperature variations, which affect the reference frequency supplied, e.g., by the XO, the delta M over T value (DELMT) value is supplied to summing circuit 315 along with the reference frequency control value RFREQ. Thus, the control value generated at the reference temperature calibration point, along with an interpolated delta as described above, is supplied to summer 315 and utilized to generate the M value. Note that other temperature calibration algorithms besides the interpolation described above may be utilized. That function, in the embodiment illustrated in Fig. 4, is performed by the control circuit 341.

Referring to Fig. 8, illustrated is an exemplary embodiment of the digitally controlled oscillator (DCO) 301. The crystal (or SAW) oscillator 303 supplies a timing reference to the DCO 301 and supplies one input to the phase and frequency detector 801. Phase and frequency detector 801 generates an error term of the difference between the crystal oscillator input and the feedback from the VCO 805. Note that the feedback is supplied by multi-modulus divider block 807. In the embodiment illustrated in Fig. 8, the DCO is a fractional N loop. During calibration, the DCO 301 functions as an inner loop having its feedback divider controlled by an outer loop that includes the dividers 335, 347, phase detector and analog to digital converter 851, filter 853, delta sigma modulator 809 as well as portions of the inner loop. The inner loop or DCO 301 is a fractional N loop wherein a period of the reference clock supplied by crystal or SAW 303 is a non-integer multiple of a period of the oscillator clock signal supplied by VCO 805. Using a fractional N loop allows the use of low cost timing reference such as a low cost crystal oscillator. During normal operation, the DCO receives a control value from summing circuit 315 based on ADC 311, DELMT, and RFREQ. Thus, the temperature compensation is achieved by adjusting the feedback loop of the DCO 301 through the delta sigma modulator 809, which is coupled to adjust the divider value supplied to the divide block 807.

Note that the inner loop forming DCO 301 utilizes a digital loop filter to allow the loop filter to be integrated onto the integrated circuit to reduce potential additional noise sources. Further, as described above, utilization of a digital loop filter allows an accurate implementation of the loop filter that is properly matched to the corners and the order of the noise shaping function and therefore can best reduce the jitter contribution from that source.

In one embodiment, the multi-modulus divider 807 is formed by a series of dividers. Because the feedback frequency may be in the GHz range, a prescalar is used to divide the feedback signal by, e.g., 4 or 5. Subsequent division stages, e.g., a plurality of divide by 4 and/or 5 stages further divide the feedback signal to an appropriate value according to the desired divider value.

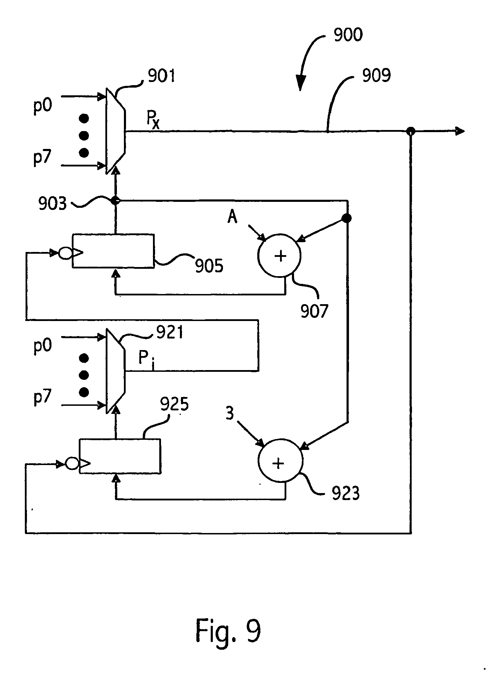

Referring to Fig. 9 a block diagram of an exemplary phase selectable divider 900 is illustrated that may be utilized as part of the multi-modulus divider 807. Eight clock signals P0-P7 are supplied to selector circuit 901. In the illustrated embodiment, selector circuit 901 is implemented as a multiplexer. A three bit control signal 903 supplied from register 905 selects which of the clock signals P0 to P7 is output by the selector circuit. The clock signals P0-P7 have different phases. By selecting which clock signals are supplied by multiplexer 901, different frequency clock signals can be generated by the divider circuit.

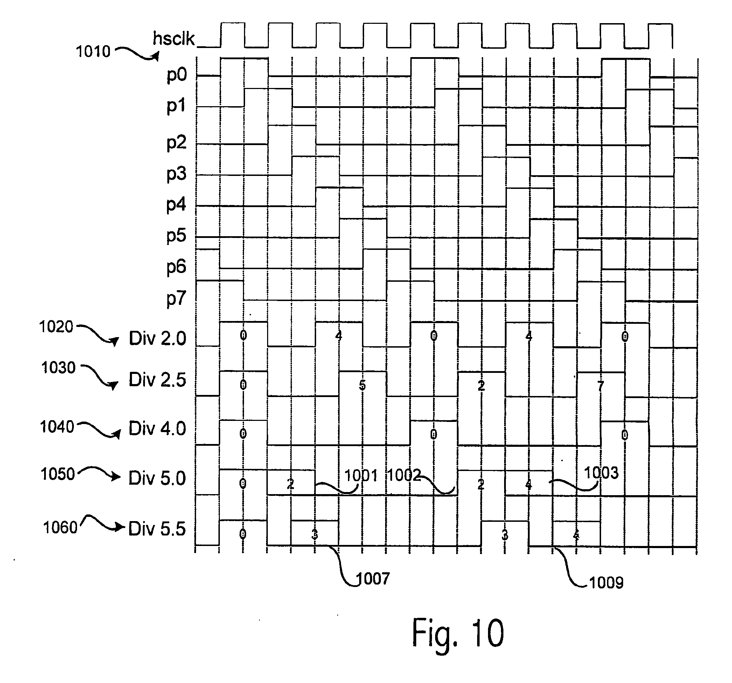

Referring to Fig. 10, a timing diagram illustrates operation of the divider circuit 900. As shown in Fig. 10, the clock signals P0-P7 are derived from a clock 1010 shown as hsclk. In one embodiment hsclk 1010 is approximately 2.5 gigahertz and the clock signals P0-P7 are one fourth of clock signal hsclk, approximately 625 MHz. Referring again to Fig. 9, the divider circuit 900 selects the next pulse to be output by adding a value A to the current select signal 903 in summing circuit 907 to generate a sum that is supplied to register 905. The table below illustrates values of A supplied to summing circuit 907 to achieve various divide values.

| Table 1 | | |
|---|---|---|
| A(mod 8) | A' (effective A) | Division Factor |
| 1 | 1 | 0.5 |
| 2 | 2 | 1.0 |
| 3 | 3 | 1.5 |
| 4 | 4 | 2.0 |
| 5 | 5 | 2.5 |
| 6 | 6 | 3.0 |
| 7 | 7 | 3.5 |
| 0 | 8 | 4.0 |
| 1 | 9 | 4.5 |
| 2 | 10 | 5.0 |
| 3 | 11 | 5.5 |

the use of the divider circuit 900 to generate a clock signal that is divided down from the hsclk signal will now be illustrated with reference to Fig. 10. Assume it is desired to divide the hsclk signal by 2.

Referring to the table above, it can be seen that in order to divide by 2 (the division factor), the appropriate value of A is 4. Assume that the currently selected clock is P0, so the select signal supplied from register 905 will be configured to select P0, e.g., using a value of 000. In order to select the next pulse output by the multiplexer, the summing circuit 407 adds the current value supplied from register 905 (which is 000) with the value of A (which is 4) and provides a sum of 4 to register 905 to select P4 as the next pulse output by multiplexer 901, as illustrated by the clock signal 1020 (Div 2.0) shown in Fig. 10. The sum circuit 907 is implemented as a modulo N summing circuit where N equals the number of clock signals supplied to multiplexer 401, which is 8 in the illustrated embodiment. With 4 as the current value of the select signals supplied by register 905, the next value supplied as the select signal is 0, which selects P0 as the next pulse to be output by the select circuit 901. That is, 4 (the value of the select signal) + 4 (the value of A) = 0 in a modulo 8 summing circuit. A is continually added to the current select value to generate the next pulse and a sequence of pulses selected from the phases P0 and P4 is output as shown in Fig. 10 to generate an output clock signal that equals hsclk/2.

A divide by 2.5 will now be described. Assume that the currently selected clock is P0, so the select signal on control lines 903 will be configured to select P0, e.g., using a value of 000. Referring to Table 1, in order to divide by 2.5 (the division factor), the value of A is 5. The summing circuit 907 provides a sum of 5 to register 905 to select P5 as the next pulse output by multiplexer 901, as illustrated by the clock signal 1030 (Div 2.5) shown in Fig. 10. With 5 as the current value of the select signals, the next value supplied as the select signal is 2, which selects P2 as the next pulse to be output by the select circuit 901. That is, 5 (the value of the select signal) + 5 (the value of A) = 2 in a modulo 8 summing circuit. A is added to the current select value to generate the next select value, which is supplied to the select circuit. The next pulse selected is P7.

In the general case, for the circuit shown in Fig. 9, given 8 phases of a clock, with p(n) being the phase selected at a time "n", phase selection is accomplished by $p(n+1) = (p(n) + A)$ mod 8. Fig. 10 also shows the pulses 540, 550, 560, selected, respectively for divide by 4, 5 and 5.5.

Referring to Table 1, note that for the embodiment illustrated in Fig. 9, the first three divide values (0.5, 1.0, 1.5) are not available. Also for longer divide operations, for example, divide by 4.5, 5, or 5.5, where M= 1, 2, or 3, the first pulses output in the longer divides need to be ignored. This is illustrated in Fig. 10. Thus, for example, for a divide by 5, and assuming P0 is the initial pulse out, and A=2, the first P2 pulse 1001 is ignored but the second P2 pulse is supplied by multiplexer 901. Similarly, after the second P2 pulse 1002 is supplied, the first P4 pulse 1003 is ignored. With the first pulse ignored each time, the effective value of A=9. The resultant waveform 1050 supplied on node 909 is labeled Div 5.0 in Fig. 10. Similarly, the initial pulses 1007 and 1009 shown in Fig. 10 are ignored in a divide by 5.5 as shown in waveform 1060.

Referring again to Fig. 9, in order to achieve the necessary delay for the longer divides, e.g., the divide by 5 and 5.5 shown in Fig. 10, in one embodiment a second selector circuit 921 is utilized with a second summer circuit 923 and a second register 925. A skip delay value of 3 is added to the current select value 903 in summing circuit 923. The skip delay indicates how many phase steps (each of clocks P0 - P7 being a phase step) should be skipped before the select signal in register 905 is updated. As shown in Fig. 9, the output clock from multiplexer 901 on node 909 is used to update register 925 with the sum from summing circuit 923. The clock selected by multiplexer 921 is used to update the register 905. That ensures that the value of the select signals do not change until after the first pulses have been skipped for A equal to 1, 2, or 3. For example, if the currently selected clock is P0 and A=1, with a skip count of 3, register 905 is not updated until P3, thereby ensuring that the first P1 pulse is skipped. Referring to Fig. 10, a skip delay of three ensures that the undesirable pulses 1001, 1003, 1007, and 1009 are not output. Note that in some embodiments, the multiplexer 901 may be coupled to receive an input signal that is a steady state input signal, e.g., ground, in addition to the various phase sets received. In that way, the multiplexer may be selected to output no signal.

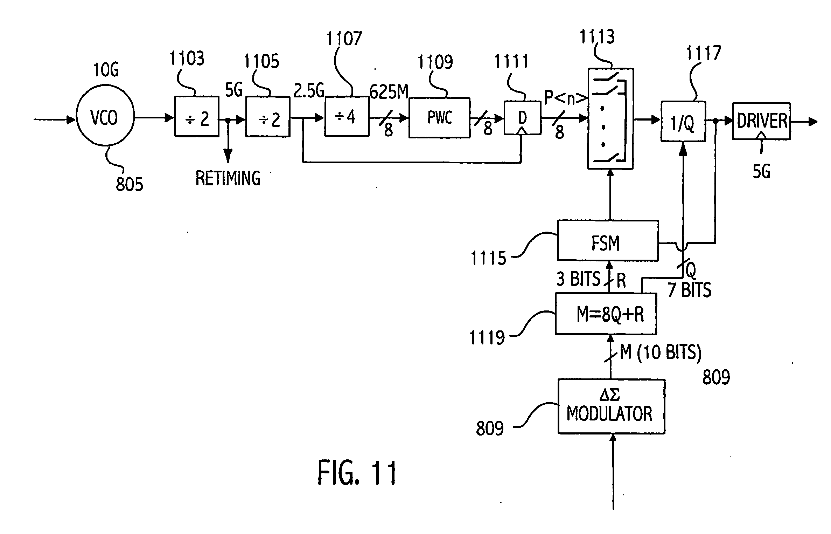

Fig. 11 illustrates an embodiment of how a multi-modulus divider such as that illustrated in Fig. 9 may be utilized in the DCO 301 shown in Fig. 8. Referring to Fig. 11, a block diagram illustrates a multi-modulus programmable divider circuit according to an embodiment of the invention. The VCO 805 provides an approximately 10 GHz clock signal, which is divided down in dividers 1103 and 1105 to an approximately 2.5 GHz clock signal. In order to operate the divider at a high frequency with low power consumption, some embodiments avoid feeding control signals to the high-speed circuitry. Instead, one embodiment utilizes a minimum number of transistors in the high speed portion to save power and take advantage of the multiphase output of a divider described herein to achieve equivalent speed. The programmability is pushed into the lower frequency circuitry. The 5 GHz signal from node 1103 is fed to a cascade of two dividers, divider 1105, which is a divide-by-two and divider 1107, which is a divide-by-four phase generator that generates 8 different phases. Divider 1107 supplies pulse width controller (PWC) 1109, which in turns supplies an 8-to-1 phase selecting multiplexer 1113 through flip-flops 1111. The phase selecting multiplexer 1113 directs one of the eight (8) phases from the PWC 1109 to its output. The output of the multiplexer 1113 is used to clock a divide-by-Q counter (/Q) 1117, which generates the divider output. The output is also used to trigger a finite state machine (FSM) 1115, which implements the multiplexer control (phase selection) algorithm, e.g. as illustrated in Figs. 9-10.

In one embodiment, as illustrated in Fig. 11, the delta sigma modulator 809 supplies a stream of integers M' to block 1119 by to provide fractional n divide capability. M' is a sequence of integers that approximates the rational number M. Note that in some embodiments, block 1119 may be incorporated into the finite sate machine 1115. Assuming the input frequency is $f_{in}$ and the output frequency is $f_{out}$, the divide ratio M = $f_{in}/f_{out}$. In one embodiment M = ((9.7 GHz ~ 11.32 GHz)/2)/(10 MHz (Xoxc) ~ 320 MHz (SAW)). Thus, M = 15.15625 ~ 566. In one embodiment the delta sigma modulator is an eight level quantizer that expands the fractional range to M-3 to M+4 as illustrated in Fig. 15. The delta sigma modulator may be implemented, e.g., as a third order delta sigma modulator. Given that expansion of the fractional range of M, M ranges from approximately 12 to approximately 570. The divider circuit illustrated in Fig. 11 operates fundamentally as an integer divider with the M' value updated at a frequency varying from approximately 416 MHz for an M value of 12, to an update frequency of approximately 9 MHz for an M value of 570.

The operation of the divider described in Fig. 11 can be understood from the following arithmetic expression:

$$8 \overline{)M'} \,^{Q}$$
$$\underline{-8Q}$$
$$R$$

where Q is the quotient and R is the remainder, and M' is the divider ratio. From that arithmetic expression, the divide ratio M' = 8Q + R. The divide ratio is thus split into a constant coefficient (here 8, although other numbers are of course possible) multiplied by a quotient Q, which is >= 1 and a remainder (R). The R portion is implemented through the phase-selecting multiplexer 1113 being controlled by the finite state machine (FSM) 1115. Control logic 1119 receives the divide ratio M', splits it into two portions, a Q number and an R number. The Q number is sent to Q divider 1117 input bits, while the R number is used by the finite state machine 1115. The 8Q value can be understood as a coarse tuning capability, while the R value provides a finer tune capability.

The divide by 8, the constant coefficient, can be accomplished in the higher speed divide circuits 1105 and 1107. The divide by Q and the divide by R can be performed in lower speed circuitry. The divide by Q can be performed in variable divider circuit 1117, which has a much lower input frequency, thus can be implemented with low speed circuitry. The divide by R can be achieved in the phase selecting multiplexer 1113. The multiplexer 1113 chooses the phase that is R steps offset (R can be positive or negative) from the last phase in each cycle of the output, thus achieving the division factor 8Q+R. R is similar to A utilized in Figs. 9 and 10. By varying both Q and R, flexible programmability is achieved. Various values of R may be utilized examples of which are shown below.

R = (-4, -3, -2, -1, 0, 1, 2, 3)
R= (-3, -2, -1, 0, 1, 2, 3, 4),
R= (-2, -1, 0, 1, 2, 3, 4, 5),
R= (-1, 0, 1, 2, 3, 4, 5, 6),
R= (0, 1, 2, 3, 4, 5, 6, 7)

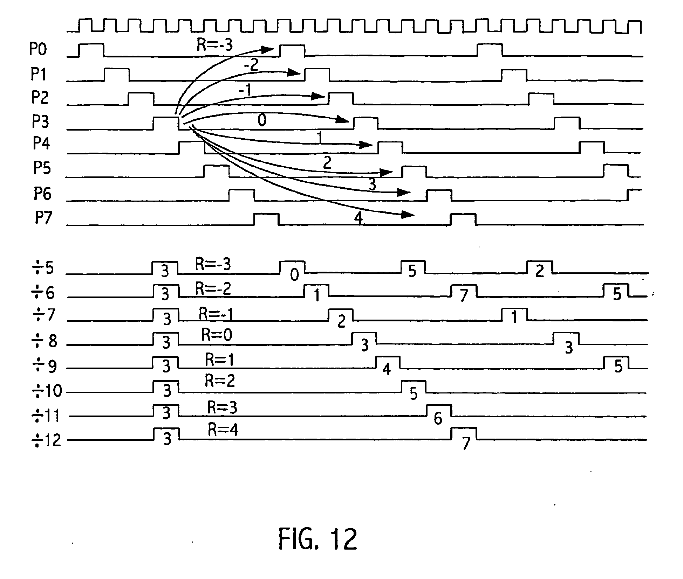

In each R scheme shown above, there are 8 values corresponding to each phase step. The R scheme chosen determines the minimum available division ratio and the maximum input frequency at the input of Q counter. For example, comparing scheme R= (-4, -3, -2, -1, 0, 1, 2, 3) to R=(0, 1, 2, 3, 4, 5, 6, 7), the first scheme can achieve the minimum divide ratio of /3, while the second one can only achieve the minimum divide ratio of /8. However the first scheme requires the Q counter to be able to operate at a much higher frequency. It also imposes tighter timing requirement on multiplexer control signal generation compared to other R scheme. It also consumes more power and may require custom design of the digital circuitry. Operation of R= (-3, -2, -1, 0, 1, 2, 3, 4), is illustrated in Fig. 12.

The top portion of Fig. 12 illustrates the input to the phase selecting multiplexer 1113, while the bottom portion of Fig. 12 illustrates the output for various divide values.

The use of the delta sigma modulator in a fractional N loop is illustrated in the following. Assume for example, that the value of M is 100 to achieve a desired nominal output frequency from DCO 301 (Fig. 3). The temperature compensation value determined by the interpolation described above may cause the value of M with temperature compensation to be 100.5. The delta sigma modulator in one embodiment provides an output having 8 different integer levels from -3 to 4, to represent the fractional portion, which values are combined with the integer portion (100) and mapped into the dividers of multi-modulus divide by N block 807. Thus, values ranging from 97 to 104 may be applied as divider values to the multi-modulus divide by N block 807. The use of the delta sigma modulator allows appropriate values to be used to average 100.5. Note that a value is generated by the divide block 807 at a rate of the XO (or other reference) clock frequency supplied on node 800. Note also that noise shaping may be used to place any noise generated in the feedback divider in a frequency band that may be subsequently filtered by a low pass filter in the loop filter 803.

Referring again to Fig. 8, in another embodiment, the integrated circuit illustrated is coupled as a clock multiplier circuit to multiply the reference signal REF received at divider 335 and the supply the multiplied value as the output of DCO 301. In that case phase detector and loop filter 337 supply a digital value to multiplexer 853, which in turn is supplied to delta sigma modulator 809. The multiplier value may be selected by setting the divide values in divide blocks 335 and 347. In various embodiments those values may be pin programmable, programmed via a serial port, or predetermined. When being used as a clock multiplier, the outer loop bandwidth is low to minimize jitter transfer from jitter present in the reference signal REF.

Note that the terms "pin" and "terminal" as used herein are intended to refer to any kind of electrical connection provided on a package or integrated circuit such as a pin on a package or a contact pad on an integrated circuit. The term input/output (I/O) terminal (or pin) is intended to mean either a terminal that functions as an input, an output or both.

Thus, various embodiments have been described for implementing a clock source. The description of the invention set forth herein is illustrative, and is not intended to limit the scope of the invention as set forth in the following claims. For example, while a PLL has been described other control loops, such as a frequency locked loop may be utilized to generate appropriate correction/control values to calibrate the oscillator. Other variations and modifications of the embodiments disclosed herein, may be made based on the description set forth herein, without departing from the scope of the invention as set forth in the following claims.

**Claims**

1. An apparatus comprising:

   a phase-locked loop (PLL) circuit (301) including an input for receiving a first timing reference signal (303), a controllable oscillator circuit (805), and a multi-modulus feedback divider circuit (807);
   a control loop circuit (347, 337, 301) including a phase detector (337), the phase detector (337) being coupled to an output of the controllable oscillator circuit (805) and a second timing reference signal (333), the control loop circuit being adapted to generate a control signal;
   **characterized in that** the apparatus includes a non-volatile memory (349) for storing a value of said control signal corresponding to a desired frequency of an output signal of the controllable oscillator circuit (805);
   and **in that** the apparatus further comprises a selector circuit (319) having inputs coupled respectively to the control signal from the phase detector (337) of the control loop circuit and to a first control signal corresponding to the stored value in the non-volatile memory (349), the selector circuit (319) being adapted to select one of the inputs as a digital control signal, the digital control signal being coupled to the feedback divider circuit (807) through a delta sigma modulator (809) and used to control a divide ratio of the feedback divider circuit (807).

2. The apparatus as recited in claim 1 wherein the selector circuit (319) is further coupled through an arithmetic circuit (315) to the delta sigma modulator (809).

3. The apparatus as recited in claim 1 or 2 wherein, while the control loop circuit (347, 337, 301) is coupled to supply the digital control signal, the digital control signal is determined according to a detected difference between, the output signal of the controllable oscillator circuit (805) and the second timing reference signal (333) coupled to the control loop circuit (347, 337, 301).

4. The apparatus as recited in claim 1, 2 or 3 further comprising, while the first control signal is selected as the digital control signal by the selector circuit (319), a temperature compensation circuit is coupled to supply an adjustment value according to a detected temperature, wherein the digital control signal is adjusted according to the adjustment value.

5. The apparatus as recited in any of claims 1 to 4 further comprising an analog to digital converter circuit (311) coupled to a voltage control input, wherein the digital control signal is adjusted according to a voltage value present on the voltage control input while the first control signal is selected as the digital control signal by the selector circuit (319).

6. The apparatus as recited in claim any of claims 1 to 5 further comprising one of a crystal oscillator and a surface acoustic wave (SAW) resonator supplying the timing reference signal.

7. The apparatus as recited in any of claims 1 to 6 wherein the control loop circuit (347, 337, 301) is a phase-locked loop and includes a digital loop filter.

8. The apparatus as recited in any of claims 1 to 7 wherein the stored value in the non-volatile memory (319) is based on a control value that was stored as a result of the control loop circuit (347, 337, 301) detecting a lock condition indicating that the output signal of the controllable oscillator circuit (805) was locked to the second timing reference signal coupled to the control loop circuit (347, 337, 301).

9. The apparatus as recited in any of claims 1 to 8 wherein the control loop circuit (347, 337, 301) is implemented as a low bandwidth phase-locked loop and a bandwidth of the PLL circuit (301) is substantially higher than the low bandwidth of the control loop circuit (347, 337, 301).

10. A method comprising:

providing a phase-locked loop (PLL) circuit (301) including an input for receiving a first timing reference signal (303), a controllable oscillator circuit (805), and a multi-modulus feedback divider circuit (807);

providing a control loop circuit (347, 337, 301) including a phase detector (337) coupled to receive an output of the controllable oscillator circuit (805) and a second timing reference signal (333);

**characterized by** the steps of:

storing a stored value corresponding to a desired frequency of an output signal of the controllable oscillator circuit (805) in a non-volatile memory (349);

selecting in a selector circuit (319) a source for a control value for controlling a divide ratio of the feedback divider circuit (807) to be from one of the control loop circuit (347, 337, 301) and a stored value stored in the non-volatile memory (349) indicative of a desired frequency of an output signal of the PLL circuit (301); and

supplying the control value to control the divide ratio to the feedback divider circuit (807) through a delta sigma modulator (809).

11. The method as recited in claim 10 further comprising:

supplying the PLL circuit (301) with a fisrt timing reference signal from one of a crystal oscillator and a surface acoustic wave (SAW) device (303).

12. The method as recited in claim 10 or 11 wherein the PLL circuit (301) is a fractional N loop such that a period of the timing reference signal can be a non-integer multiple of a period of an output signal generated by the PLL circuit (301), and wherein the control loop circuit (347, 337, 301) is a low bandwidth phase-locked loop and PLL circuit is a phase-locked loop having a substantially higher bandwidth than the low bandwidth of the control loop circuit (347, 337, 301).

13. The method as recited in claim 10, 11 or 12 further comprising determining the divide ratio at least in part according to a detected temperature.

14. The method as recited in any of claims 10 to 13 further comprising:

converting a control voltage received on a voltage control input terminal to a digital representation thereof in an analog to digital converter circuit (311); and

adjusting the divide ratio by arithmetically combining the digital representation of the control voltage with the control value that corresponds to the stored value.

15. The method as recited in any of claims 10 to 14, further comprising:

while the selector circuit (319) is selecting the control loop circuit (347, 337, 301) as the source, the control loop comparing an output from the PLL circuit (301) and the second timing reference signal (333) and providing an indication thereof for controlling the divide ratio; and

storing in the non-volatile memory (349) a control signal corresponding to the divide ratio supplied to the PLL circuit (301) to cause the PLL circuit (301) to generate the output signal with a frequency corresponding to the second timing reference signal (333), in response to a lock condition detected by the control loop circuit (347, 337, 301).

**Patentansprüche**

1. Vorrichtung, Folgendes umfassend:

eine PLL(Phasenregelkreis)-Schaltung (301) einschließlich eines Eingangs zum Empfangen eines ersten Timing-Referenzsignals (303), einer steuerbaren Oszillatorschaltung (805) und einer Multimodulus-Feedback-Teilerschaltung (807);

eine Steuerschleifenschaltung (347, 337, 301) einschließlich eines Phasendetektors (337), wobei der Phasendetektor (337) an einen Ausgang der steuerbaren Oszillatorschaltung (805) und ein zweites Timing-Referenzsignal (333) angeschlossen ist, wobei die Steuerschleifenschaltung dazu angepasst ist, ein Steuersignal zu erzeugen;

**dadurch gekennzeichnet, dass** die Vorrichtung einen nichtflüchtigen Speicher (349) zum Speichern eines Werts des Steuersignals umfasst, der einer gewünschten Frequenz eines Ausgangssignals der steuerbaren Oszillatorschaltung (805) entspricht;

und dadurch, dass die Vorrichtung außerdem eine Selektorschaltung (319) mit Eingängen umfasst, die an das Steuersignal vom Phasendetektor (337) der Steuerschleifenschaltung bzw. an ein erstes Steuersignal gekoppelt sind, das dem gespeicherten Wert im nichtflüchtigen Speicher (349) entspricht, wobei die Selektorschaltung (319) dazu angepasst ist, eine der Eingaben als ein digitales Steuersignal auszuwählen, wobei das digitale Steuersignal über einen Delta-Sigma-Modulator (809) an die Feedback-Teilerschaltung (807) gekoppelt ist und dazu verwendet wird, ein Teilungsverhältnis der Feedback-Teilerschaltung (807) zu steuern.

2. Vorrichtung nach Anspruch 1, worin die Selektorschaltung (319) außerdem über eine Arithmetikschaltung (315) an den Delta-Sigma-Modulator (809) gekoppelt ist.

3. Vorrichtung nach Anspruch 1 oder 2, worin, während die Steuerschleifenschaltung (347, 337, 301) angekoppelt ist, um das digitale Steuersignal anzulegen, das digitale Steuersignal gemäß einer detektierten Differenz zwischen dem Ausgangssignal der steuerbaren Oszillatorschaltung (805) und dem an die Steuerschleifenschaltung (347, 337, 301) gekoppelten zweiten Timing-Referenzsignal (333) bestimmt wird.

4. Vorrichtung nach Anspruch 1, 2 oder 3, außerdem Folgendes umfassend: während das erste Steuersignal von der Selektorschaltung (319) als das digitale Steuersignal ausgewählt wird, ist eine Temperaturkompensationsschaltung angekoppelt, um einen Anpassungswert gemäß einer detektierten Temperatur bereitzustellen, worin das digitale Steuersignal gemäß dem Anpassungswert angepasst wird.

5. Vorrichtung nach einem der Ansprüche 1 bis 4, außerdem eine Analog-Digital-Wandlerschaltung (311) umfassend, die an einen Spannungssteuerungseingang gekoppelt ist, worin das digitale Steuersignal gemäß einem Spannungswert angepasst wird, der am Spannungssteuerungseingang vorhanden ist, während das erste Steuersignal von der Selektorschaltung (319) als das digitale Steuersignal ausgewählt wird.

6. Vorrichtung nach einem der Ansprüche 1 bis 5, außerdem einen von Folgenden umfassend: einen Kristalloszillator und einen SAW(akustische Oberflächenwelle)-Resonator, der das Timing-Referenzsignal bereitstellt.

7. Vorrichtung nach einem der Ansprüche 1 bis 6, worin die Steuerschleifenschaltung (347, 337, 301) ein Phasenregelkreis ist und ein digitales Schleifenfilter enthält.

8. Vorrichtung nach einem der Ansprüche 1 bis 7, worin der gespeicherte Wert im nichtflüchtigen Speicher (319) auf einem Steuerwert basiert, der daraus resultierend gespeichert wurde, dass die Steuerschleifenschaltung (347, 337, 301) eine Verriegelungsbedingung detektiert, die anzeigt, dass das Ausgangssignal der steuerbaren Oszillatorschaltung (805) phasenstarr mit dem zweiten Timing-Referenzsignal verriegelt war, das an die Steuerschleifenschaltung (347, 337, 301) gekoppelt ist.

9. Vorrichtung nach einem der Ansprüche 1 bis 8, worin die Steuerschleifenschaltung (347, 337, 301) als ein Niedrigbandbreiten-Phasenregelkreis implementiert ist und eine Bandbreite der PLL-Schaltung (301) wesentlich größer ist als die Niedrigbandbreite der Steuerschleifenschaltung (347, 337, 301).

10. Verfahren, Folgendes umfassend:

Bereitstellen einer PLL(Phasenregelkreis)-Schaltung (301) einschließlich eines Eingangs zum Empfangen eines ersten Timing-Referenzsignals (303), einer steuerbaren Oszillatorschaltung (805) und einer Multimodulus-Feedback-Teilerschaltung (807);
Bereitstellen einer Steuerschleifenschaltung (347, 337, 301) einschließlich eines Phasendetektors (337), der angekoppelt ist, um eine Ausgabe der steuerbaren Oszillatorschaltung (805) und ein zweites Timing-Referenzsignal (333) zu empfangen;
**gekennzeichnet durch** folgende Schritte:

Speichern eines einer gewünschten Frequenz eines Ausgangssignals der steuerbaren Oszillatorschaltung (805) entsprechenden gespeicherten Werts in einem nichtflüchtigen Speicher (349);
in einer Selektorschaltung (319) eine Quelle für einen Steuerwert auswählen, um ein Teilungsverhältnis der Feedback-Teilerschaltung (807) so zu steuern, dass es aus einem von Folgenden kommt: der Steuerschleifenschaltung (347, 337, 301) und einem gespeicherten Wert, der im nichtflüchtigen Speicher (349) gespeichert ist und eine gewünschte Frequenz eines Ausgangssignals der PLL-Schaltung (301) anzeigt; und

Bereitstellen des Steuerwerts zum Steuern des Teilungsverhältnisses an die Feedback-Teilerschaltung (807) **durch** einen Delta-Sigma-Modulator (809).

**11.** Verfahren nach Anspruch 10, außerdem umfassend:

an die PLL-Schaltung (301) ein erstes Timing-Referenzsignal von einem von Folgenden anlegen: einem Kristalloszillator und einer SAW(akustische Oberflächenwelle)-Einrichtung (303).

**12.** Verfahren nach Anspruch 10 oder 11, worin die PLL-Schaltung (301) eine Fraktional-N-Schleife ist, sodass eine Periode des Timing-Referenzsignals ein nichtganzzahliges Vielfaches einer Periode eines Ausgangssignals sein kann, das von der PLL-Schaltung (301) erzeugt wird, und worin die Steuerschleifenschaltung (347, 337, 301) ein Niedrigbandbreiten-Phasenregelkreis ist und die PLL-Schaltung ein Phasenregelkreis ist mit einer wesentlich größeren Bandbreite als die Niedrigbandbreite der Steuerschleifenschaltung (347, 337, 301).

**13.** Verfahren nach Anspruch 10, 11 oder 12, außerdem umfassend, dass das Teilungsverhältnis mindestens teilweise gemäß einer detektierten Temperatur bestimmt wird.

**14.** Verfahren nach einem der Ansprüche 10 bis 13, außerdem umfassend:

Umwandeln einer an einem Spannungssteuerungs-Eingangsanschluss empfangenen Steuerspannung in deren digitale Repräsentation in einer Analog-Digital-Wandlerschaltung (311); und

Anpassen des Teilungsverhältnisses durch arithmetisches Kombinieren der Digitalrepräsentation der Steuerspannung mit dem Steuerwert, der dem gespeicherten Wert entspricht.

**15.** Verfahren nach einem der Ansprüche 10 bis 14, außerdem umfassend:

während die Selektorschaltung (319) die Steuerschleifenschaltung (347, 337, 301) als die Quelle auswählt, vergleicht die Steuerschleife eine Ausgabe aus der PLL-Schaltung (301) und das zweite Timing-Referenzsignal (333) und stellt eine Anzeige davon zum Steuern des Teilungsverhältnisses bereit; und

Speichern eines Steuersignals im nichtflüchtigen Speicher (349), dem Teilungsverhältnis entsprechend, das der PLL-Schaltung (301) bereitgestellt wird, um zu veranlassen, dass die PLL-Schaltung (301) das Ausgangssignal mit einer Frequenz erzeugt, die dem zweiten Timing-Referenzsignal (333) entspricht, als Reaktion auf eine von der Steuerschleifenschaltung (347, 337, 301) detektierte Verriegelungsbedingung.

**Revendications**

**1.** Dispositif comprenant :

un circuit à boucle à verrouillage de phase (PLL) (301), comportant une entrée pour recevoir un premier signal de référence de temporisation (303), un circuit oscillateur contrôlable (805), et un circuit diviseur à rétroaction et modules multiples (807) ;

un circuit à boucle de commande (347, 337, 301) comportant un détecteur de phase (337), le détecteur de phase (337) étant couplé à une sortie du circuit oscillateur contrôlable (805) et à un second signal de référence de temporisation (333) ; le circuit à boucle de commande étant apte à générer un signal de commande ;

**caractérisé en ce que** le dispositif comprend une mémoire non volatile (349) pour stocker une valeur dudit signal de commande correspondant à une fréquence désirée d'un signal de sortie du circuit oscillateur contrôlable (805) ;

et **en ce que** le dispositif comprend en outre un circuit sélecteur (319) présentant des entrées couplées respectivement au signal de commande en provenance du détecteur de phase (337) du circuit à boucle de commande, et à un premier signal de commande correspondant à la valeur stockée dans la mémoire non volatile (349), le circuit sélecteur (319) étant apte à sélectionner l'une des entrées en qualité de signal de commande numérique, le signal de commande numérique étant couplé au circuit diviseur à rétroaction (807) via un modulateur sigma delta (809) et étant utilisé en vue de commander un taux de division du circuit diviseur à rétroaction (807).

**2.** Dispositif selon la revendication 1, dans lequel le circuit sélecteur (319) est en outre couplé, à travers un circuit de calcul arithmétique (315), au modulateur sigma delta à rétroaction (809).

**3.** Dispositif selon la revendication 1 ou 2, dans lequel, alors que le circuit à boucle de commande (347, 337, 301) est couplé de manière à fournir le signal de commande numérique, le signal de commande numérique est déterminé selon une différence détectée entre le signal de sortie du circuit oscillateur contrôlable (805) et le second signal de référence de temporisation (333) couplé au circuit à boucle de commande (347, 337, 301).

**4.** Dispositif selon la revendication 1, 2 ou 3, dans lequel en outre, alors que le premier signal de commande est sélectionné en qualité de signal de commande numérique par le circuit sélecteur (319), un circuit de compensation thermique est couplé en vue de fournir une valeur d'ajustement selon une température détectée, dans lequel le signal de commande numérique est ajusté selon la valeur d'ajustement.

**5.** Dispositif selon l'une quelconque des revendications 1 à 4, comprenant en outre un circuit de conversion analogique à numérique (311) couplé à une entrée de commande de tension, dans lequel le signal de commande numérique est ajusté selon une valeur de tension présente au niveau de l'entrée de commande de tension tandis que le premier signal de commande est sélectionné en qualité de signal de commande numérique par le circuit sélecteur (319).

**6.** Dispositif selon l'une quelconque des revendications 1 à 5, comprenant en outre l'un parmi un oscillateur à quartz et un résonateur à ondes acoustiques de surface (SAW) fournissant le signal de référence de temporisation.

**7.** Dispositif selon l'une quelconque des revendications 1 à 6, dans lequel le circuit à boucle de commande (347, 337, 301) est une boucle à verrouillage de phase et comprend un filtre de boucle numérique.

**8.** Dispositif selon l'une quelconque des revendications 1 à 7, dans lequel la valeur stockée dans la mémoire non volatile (319) est basée sur une valeur de commande qui a été stockée suite à la détection, par le circuit à boucle de commande (347, 337, 301), d'un état de verrouillage indiquant que le signal de sortie du circuit oscillateur contrôlable (805) a été verrouillé sur le second signal de référence de temporisation couplé au circuit à boucle de commande (347, 337, 301).

**9.** Dispositif selon l'une quelconque des revendications 1 à 8, dans lequel le circuit à boucle de commande (347, 337, 301) est mis en oeuvre sous la forme d'une boucle à verrouillage de phase à faible bande passante, et une bande passante du circuit à boucle PLL (301) est sensiblement supérieure à la faible bande passante du circuit à boucle de commande (347, 337, 301).

**10.** Procédé comprenant les étapes ci-dessous consistant à :

fournir un circuit à boucle à verrouillage de phase (PLL) (301) comportant une entrée pour recevoir un premier signal de référence de temporisation (303), un circuit oscillateur contrôlable (805), et un circuit diviseur à rétroaction et modules multiples (807) ;
fournir un circuit à boucle de commande (347, 337, 301) comportant un détecteur de phase (337) couplé de manière à recevoir une sortie du circuit oscillateur contrôlable (805) et un second signal de référence de temporisation (333) ;
**caractérisé par** les étapes ci-dessous consistant à :

stocker une valeur stockée correspondant à une fréquence désirée d'un signal de sortie du circuit oscillateur contrôlable (805) dans une mémoire non volatile (349) ;
sélectionner, dans un circuit sélecteur (319), une source permettant à une valeur de commande, destinée à commander un taux de division du circuit diviseur à rétroaction (807), de provenir de l'un parmi le circuit à boucle de commande (347, 337, 301) et une valeur stockée dans la mémoire non volatile (349) représentant une fréquence désirée d'un signal de sortie du circuit à boucle PLL (301) ; et
fournir la valeur de commande en vue de commander le taux de division au niveau du circuit diviseur à rétroaction (807) à travers un modulateur sigma delta (809).

**11.** Procédé selon la revendication 10, comprenant en outre l'étape ci-dessous consistant à :

fournir, au circuit à boucle PLL (301), un premier signal de référence de temporisation en provenance de l'un parmi un oscillateur à quartz et un dispositif à ondes acoustiques de surface (SAW) (303).

**12.** Procédé selon la revendication 10 ou 11, dans lequel le circuit à boucle PLL (301) est une boucle N fractionnelle, de sorte qu'une période du signal de référence de temporisation peut être un multiple non entier d'une période d'un signal de sortie généré par le circuit à boucle PLL (301), et dans lequel le circuit à boucle de commande (347, 337, 301) est une boucle à verrouillage de phase à faible bande passante, et le circuit à boucle PLL est une boucle à verrouillage de phase présentant une bande passante sensiblement supérieure à la faible bande passante du circuit à boucle de commande (347, 337,301).

**13.** Procédé selon la revendication 10, 11 ou 12, comprenant en outre l'étape consistant à déterminer le taux de division au moins en partie selon une température détectée.

**14.** Procédé selon l'une quelconque des revendications 10 à 13, comprenant en outre les étapes ci-dessous consistant à :

convertir une tension de commande reçue sur une borne d'entrée de commande de tension en une représentation numérique de celle-ci, dans un circuit de conversion analogique à numérique (311) ; et
ajuster le taux de division en associant arithmétiquement la représentation numérique de la tension de commande à la valeur de commande correspondant à la valeur stockée.

**15.** Procédé selon l'une quelconque des revendications 10 à 14, comprenant en outre les étapes ci-dessous consistant à :

tandis que le circuit sélecteur (319) sélectionne le circuit à boucle de commande (347, 337, 301) en qualité de source, comparer, par le biais de la boucle de commande, une sortie en provenance du circuit à boucle PLL (301) et le second signal de référence de temporisation (333), et fournir une indication de cela en vue de commander le taux de division ; et
stocker, dans la mémoire non volatile (349), un signal de commande correspondant au taux de division fourni au circuit à boucle PLL (301) en vue d'amener le circuit à boucle PLL (301) à générer le signal de sortie avec une fréquence correspondant au second signal de référence de temporisation (333), en réponse à un état de verrouillage détecté par le circuit à boucle de commande (347, 337, 301).

FIG. 1

FIG. 2

FIG. 3

FIG. 4

| 8 BITS | 8 BITS | 8 BITS |
|---|---|---|
| PREAMBLE | INSTRUCTION | ADDRESS/DATA[7:0] |

501                503        505
WRITE/SET ADDRESS FORMAT

| 8 BITS | 8 BITS | 1B | 8 BITS |
|---|---|---|---|
| PREAMBLE | INSTRUCTION | | ADDRESS/DATA[7:0] |

READ FORMAT

507

## FIG. 5

MANCHESTER 0          MANCHESTER 1

MANCHESTER
VIOLATIONS

## FIG. 6

P1
OR P2 | PREAMBLE | INSTRUCTION | DATA | | CAL CLK | | PREAMBLE |

LOCK

## FIG. 7

FIG. 8

EP 1 623 503 B1

Fig. 9

Fig. 10

EP 1 623 503 B1

FIG. 11

EP 1 623 503 B1

FIG. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5790614 A

- WO 0205428 A2